Europäisches Patentamt

European Patent Office

Office européen des brevets

(19)

(11) Numéro de publication: **0 314 235**
**A1**

## (12) DEMANDE DE BREVET EUROPEEN

(21) Numéro de dépôt: 88202313.8

(22) Date de dépôt: 17.10.88

(51) Int. Cl.⁴: **H03H 11/04 , H03H 11/18**

(30) Priorité: 30.10.87 FR 8715079

(43) Date de publication de la demande:
03.05.89 Bulletin 89/18

(84) Etats contractants désignés:
**DE FR GB IT**

(71) Demandeur: **Laboratoires d'Electronique et de Physique Appliquée L.E.P.**
**3, Avenue Descartes**
**F-94450 Limeil-Brévannes(FR)**

(84) **FR**

(71) Demandeur: **N.V. Philips' Gloeilampenfabrieken**
**Groenewoudseweg 1**
**NL-5621 BA Eindhoven(NL)**

(84) **DE GB IT**

(72) Inventeur: **Deville, Yannick Société Civile S.P.I.D.**
**209, rue de l'Université**
**F-75007 Paris(FR)**

(74) Mandataire: **Landousy, Christian et al**
**Société Civile S.P.I.D. 209, Rue de l'Université**
**F-75007 Paris(FR)**

(54) **Circuit formant un filtre R.C. pour application coupe-bande.**

(57) Circuit formant un filtre R.C. actif pour application dans les domaines des hautes et hyperfréquences, à fonction de transfert biquadratique, comportant une chaîne comprenant un bloc pour réaliser une fonction filtre et amplificateur, et comportant un bloc $S_3$ pour réaliser la sommation $V_S$ entre le signal de sortie de la chaîne et le signal $V_E$ appliqué à l'entrée E du circuit, caractérisé en ce que le bloc filtre est constitué de deux blocs filtre $F_1$ et $F_2$ à fonction de passe-tout chacun d'ordre 1 en série, et en ce que la chaîne comprend en outre un bloc amplificateur $A_1$ en série avec le bloc filtre $F_1$, $F_2$, placé entre la sortie de ces derniers et la sortie de la chaîne, en ce que le signal d'entrée $V_E$ est appliqué par ailleurs sur le bloc sommateur $S_3$ à travers un amplificateur $A_2$, en ce que le bloc $S_3$ sommateur est formé par le couplage des sorties des blocs amplificateurs $A_1$ et $A_2$ pour former la sortie S du circuit sur laquelle le signal de sortie $V_S$ est disponible et en ce que chaque bloc $F_1$ et $F_2$ comprend un pont déphaseur associé à un étage amplificateur. Ce circuit est continûment ajustable de coupe-bande à passe-tout.

FIG.1

## CIRCUIT FORMANT UN FILTRE ACTIF R.C. POUR APPLICATION COUPE-BANDE

### Description

L'invention concerne un circuit formant un filtre RC actif pour application coupe-bande dans les domaines des hautes et hyperfréquences, à fonction de transfert biquadratique, comportant une chaîne comprenant un bloc pour réaliser une fonction filtre et amplificateur, et comportant un bloc pour réaliser la sommation $V_S$ entre le signal de sortie de la chaîne et le signal $V_E$ appliqué à l'entrée du circuit.

L'invention trouve son application dans la réalisation de circuits intégrés formant filtres, dans le domaine des hautes et des hyperfréquences, pouvant par exemple, sous une forme de réalisation, être utilisés comme coupe-bande dans des doubleurs de fréquence pour rejeter le signal indésirable à la fréquence fondamentale ou pouvant, sous une autre forme de réalisation, être utilisés comme coupe-bande avec des entrées et sorties différentielles ; ou pouvant encore dans une autre forme de réalisation être particulièrement bien adaptés pour un réglage fin de la réjection.

Un filtre actif passe-tout (A.P. = de l'anglo-saxon ALL PASS) est déjà connu de l'état de la technique par la publication de J.TOW, dans "IEEE Spectrum, December 1969, pp.103-107", intitulée "A Step-by-Step Active-filter Design".

Cette publication décrit, entre autres, une réalisation de filtre passe-tout à fonction de transfert biquadratique, lequel filtre est représenté sur la figure 8 du document cité. Ce circuit comprend trois amplificateurs opérationnels montés en série, cette chaîne étant retrobouclée. Un quatrième amplificateur opérationnel réalise la sommation de la sortie du premier amplificateur opérationnel et de l'entrée du circuit filtre.

Les amplificateurs opérationnels qui entrent dans la constitution de ce circuit présentent un gain qui est certes infini en basses fréquences, mais qui devient très faible en hautes et hyperfréquences. Pour cette raison, le circuit connu du document cité présente l'inconvénient de ne pouvoir être utilisé dans ces domaines de fréquence.

D'autre part, la chaîne rebouclée présente l'inconvénient d'entraîner, dans certaines conditions le circuit à osciller.

La figure 6 du document cité montre aussi un filtre actif passe-bande (BP = de l'anglo-saxon BAND-PASS) qui présente des caractéristiques similaires et donc exactement les mêmes inconvénients.

Les circuits connus du document cité présentent en outre les inconvénients suivants : d'une part, ils sont formés d'un grand nombre de transistors, ce qui :
- rend le coût de fabrication élevé dans tous les cas,
- entraîne l'occupation d'une grande surface et est désavantageux pour l'application aux circuits intégrés,
- entraîne une forte consommation et est également désavantageux pour l'application citée ci-dessus.

D'autre part, leur fréquence caractéristique n'est pas ajustable.

Enfin, les capacités utilisées dans ce circuit présentent une dimension importante et font que ce circuit n'est pas intégrable.

C'est pourquoi la présente invention propose un circuit de filtre actif qui permet de s'affranchir de ces inconvénients et qui notamment :
- peut fonctionner en hautes ou en hyperfréquences ;
- et, dans le cas de l'application aux hyperfréquences est facilement intégrable et présente une faible surface et une faible consommation ;
- présente des caractéristiques telles que la fréquence de réjection et la réjection sont ajustables et facilement réglables ;
- peut admettre une entrée et une sortie en différentiel.

Selon l'invention, ce but est atteint au moyen d'un circuit tel que décrit dans le préambule caractérisé en ce que le bloc filtre est constitué de deux blocs filtre $F_1$ et $F_2$ à fonction chacun de passe-tout d'ordre 1 en série, et en ce que la chaîne comprend en outre un bloc amplificateur $A_1$ en série avec le bloc filtre $F_1$, $F_2$, placé entre la sortie de ces derniers et la sortie de la chaîne, en ce que le signal d'entrée $V_E$ est appliqué par ailleurs sur le bloc sommateur $S_3$ à travers un amplificateur $A_2$, et en ce que le bloc $S_3$ sommateur est formé par le couplage des sorties des blocs amplificateurs $A_1$ et $A_2$ pour former la sortie S du circuit sur laquelle le signal de sortie $V_S$ est disponible.

L'invention sera mieux comprise au moyen de la description suivante illustrée par les figures ci-après annexées dont :
- La figure 1 qui représente le diagramme fonctionnel du circuit selon l'invention ;

- La figure 2a qui représente un exemple de réalisation du circuit selon l'invention au moyen de transistors à effet de champ ;
- Les figures 2b et 2c qui représentent les courbes respectivement du rapport des tensions de sortie et d'entrée du circuit en fonction de la fréquence et du déphasage $\phi + \pi$ entre le signal de sortie et le signal d'entrée en fonction de la fréquence ;
- La figure 3a qui représente une variante du circuit selon l'invention ;
- La figure 3b qui représente une autre variante du circuit selon l'invention.

Pour rendre plus clair l'exposé de l'invention on rappelle tout d'abord que la fonction de transfert d'un filtre actif coupe-bande du second ordre est donné dans un tableau aux pages 94-95 de l'ouvrage intitulé "Filtres actifs" par Paul BILDSTEIN aux "Editions de la Radio" (9 rue Jacob, PARIS,-FRANCE).

Pour un filtre coupe-bande d'ordre 2 idéal, cette fonction de transfert s'écrit selon la relation (1) : du tableau I, relation dans laquelle :

s est la variable de Laplace qui se déduit de la variable p utilisée dans l'ouvrage cité (p étant la variable de Laplace réduite) par la relation (2) du tableau I, en posant d'autre part la relation (3) du tableau I.

Les autres paramètres de la fonction de transfert (1) sont définis dans l'ouvrage de référence cité tels que $\omega_1$ est la pulsation de réjection pour laquelle la fonction (1) $F(j\omega_1) = 0$ rigoureusement et donc pour laquelle la réjection est totale ;

$Q_0$ est le facteur de qualité ou sélectivité qui indique la raideur des pentes de la courbe $|F(j\omega)|$ au voisinage de $\omega_1$ ;

$\omega_0$ est la pulsation associée aux pôles de la fonction de transfert. Il a été choisi ici de faire correspondre l'écriture $\omega_1$ à l'écriture $\omega_p$ de l'ouvrage de référence cité, avec $\omega_1 = \omega_0$ dans cet ouvrage.

G est le gain du circuit à basse fréquence (lorsque $\omega \rightarrow 0$ et que $s \rightarrow 0$, le terme facteur de G se réduit à 1, et $F(j\omega) \rightarrow G$).

La fonction de transfert d'un circuit non plus idéal, mais présentant une structure fixée réelle, pour laquelle ne sont pas posées de conditions sur la valeur des éléments, est, dans le cas le plus simple, du deuxième ordre et s'exprime par la relation (4) du tableau I.

On s'intéresse ici pour des raisons pratiques de simplicité au cas où $\omega_1 = \omega_0$ quelles que soient les valeurs des éléments du filtre, et où,

$Q_1$ étant le facteur de réjection,

$|Q_1| > Q_0$ pour que le filtre fonctionne en coupe-bande, ce qui conduit à deux cas :

$Q_1 > Q_0$

et

$Q_1 < -Q_0$.

Il apparaît alors un nouveau paramètre du filtre qui est la réjection R du filtre donnée par la relation (5) du tableau I, si on suppose que $\omega_1 \simeq \omega_0$.

Plus la valeur absolue de $Q_1$ (notée $|Q_1|$) est grande, meilleure est la réjection R. La réjection R est, à la limite, totale lorsque $|Q_1|$ est infinie.

On peut alors classer les coupe-bandes réels en deux catégories :

- la première catégorie correspond au cas où $Q_1$ est fini, et supérieur à 0 ($Q_1 > 0$) quels que soient les éléments du filtre. Dans ces conditions, les filtres ne peuvent réaliser une réjection totale. C'est la valeur maximale de $Q_1$ qui fixe les limites du filtre. En effet, pour une valeur de $Q_1$ donnée, si la valeur de $Q_0$ augmente, la réjection R diminue.

- la seconde catégorie correspond au cas où le fait que $Q_1$ soit supérieur ou inférieur à 0 dépend au contraire des éléments du filtre. Dans ce cas, il existe des valeurs particulière des éléments telles que $(1/Q_1) = 0$, et où la réjection R est totale. La fonction de transfert G(s) donnée par la relation (4) se réduit alors à la fonction F(s) donnée par la relation (1).

Les filtres appartenant à la seconde catégorie présentent notamment la propriété de pouvoir être réalisés en choisissant des éléments tels que $Q_1 = -Q_0$ (et toujours $\omega_1 = \omega_0$), ce qui conduit à ce que la fonction (4) :

$|G(j\omega)| = G = $ constante.

Le filtre devient alors du type passe-tout d'ordre 2. La différence de phase entre les signaux de sortie et d'entrée passe de 0 à $-2\pi$ lorsque $\omega$ varie de 0 à l'infini.)

Le but principal de l'invention est de réaliser des filtres actifs, comportant un nombre aussi restreint que possible d'éléments afin de favoriser l'intégration, et fonctionnant en hautes et hyperfréquences.

A cet effet, les circuits intégrés des filtres selon l'invention seront favorablement réalisés sur l'arséniure de gallium (GaAs).

En outre, selon l'invention, on a choisi de réaliser des filtres actifs coupe-bandes de la seconde catégorie, ce qui permet d'obtenir entre autres avantages :
- une réjection R importante et facilement réglable ;
- une sélectivité aussi grande que celle des filtres passifs connus de l'état de la technique cité plus loin ;
- un facteur de réjection $Q_1$ continûment ajustable.

Les filtres conformes à l'invention seront avantageusement utilisés dans des doubleurs de fréquences pour rejeter le signal indésirable à la fréquence fondamentale. Le circuit selon l'invention, bien qu'étant de la seconde catégorie, ne sera pas utilisé comme passe-tout d'ordre 2. On verra en effet qu'il est lui-même réalisé au moyen de cellules passe-tout chacune d'ordre 1 dans un exemple de réalisation décrit plus loin.

Il est, d'autre part également connu de l'état de la technique des filtres coupe-bandes de la seconde catégorie fonctionnant en hautes fréquences. Mais ces circuits sont réalisés au moyen d'éléments passifs. On pourra considérer, par exemple, le circuit dit "Pont de Robinson" également connu sous le nom de "Pont de Wien", et représenté à la page 121 de l'ouvrage de référence intitulé "Electric Filters" par T.H. TURNEY (Ed. Pitman and Sons, London, England, 1945). Ce circuit, bien que capable de fonctionner en hyperfréquences, présente divers inconvénients et notamment :
- une sortie obligatoirement différentielle,
- une impédance de sortie élevée,
- un gain nul du fait qu'il est réalisé au moyen d'éléments passifs,
- d'une façon générale, des réglages difficiles et de faibles performances.

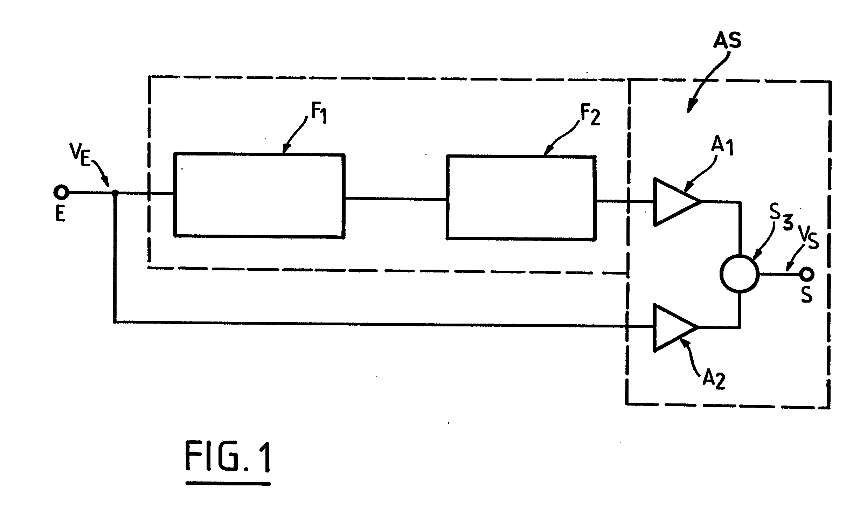

Le schéma fonctionnel du circuit coupe-bande selon l'invention est représenté sur la figure 1. Ce circuit est formé de deux parties délimitées par des traits pointillés sur cette figure 1 :
- une première partie formée des blocs $F_1$ et $F_2$ à fonction chacun de filtre passe-tout ;
- une seconde partie AS à fonction d'amplificateur sommateur.

Les blocs $F_1$ et $F_2$ ont pour fonction de transfert respectivement les relations (6) et (7) du tableau I.

Le bloc AS est formé d'un amplificateur $A_1$ de gain $k_1$ et d'un amplificateur $A_2$ de gain $k_2$. L'amplificateur $A_1$ est monté en cascade avec les blocs $F_1$ et $F_2$ alors que l'amplificateur $A_2$ est en parallèle sur la branche formée de $F_1$, $F_2$ et $A_2$. Le bloc $S_3$ fait la somme des sorties des amplificateurs $A_1$ et $A_2$, et fournit le signal de sortie $V_S$ du circuit selon l'invention, dont le signal d'entrée $V_E$ est appliqué au point commun d'entrée du bloc $F_1$ et de l'amplificateur $A_2$.

En conséquence la fonction de transfert du circuit global de la figure 1 est $G(s)$ donné par la relation (4), les paramètres étant définis par les relations (8), (9), (10), (11) et (16).

Dans ces relations :
$\tau_1$ et $\tau_2$ sont respectivement les constantes de temps associées aux pôles des blocs $F_1$ et $F_2$ ;
$\tau'_1$ et $\tau'_2$ sont respectivement les constantes de temps associées aux zéros des blocs $F_1$ et $F_2$ ;
On notera que dans le cas normal :
$\tau'_1 = \tau_1$
$\tau'_2 = \tau_2$
et $\omega_1 = \omega_0$.
On notera aussi que $Q_0$ maximal $= 1/2$ est obtenu pour $\tau_1 = \tau_2$.

Le circuit selon l'invention constitue donc un filtre coupe-bande de la seconde catégorie définie plus haut, qui peut réaliser une réjection totale.


## Exemple de réalisation I

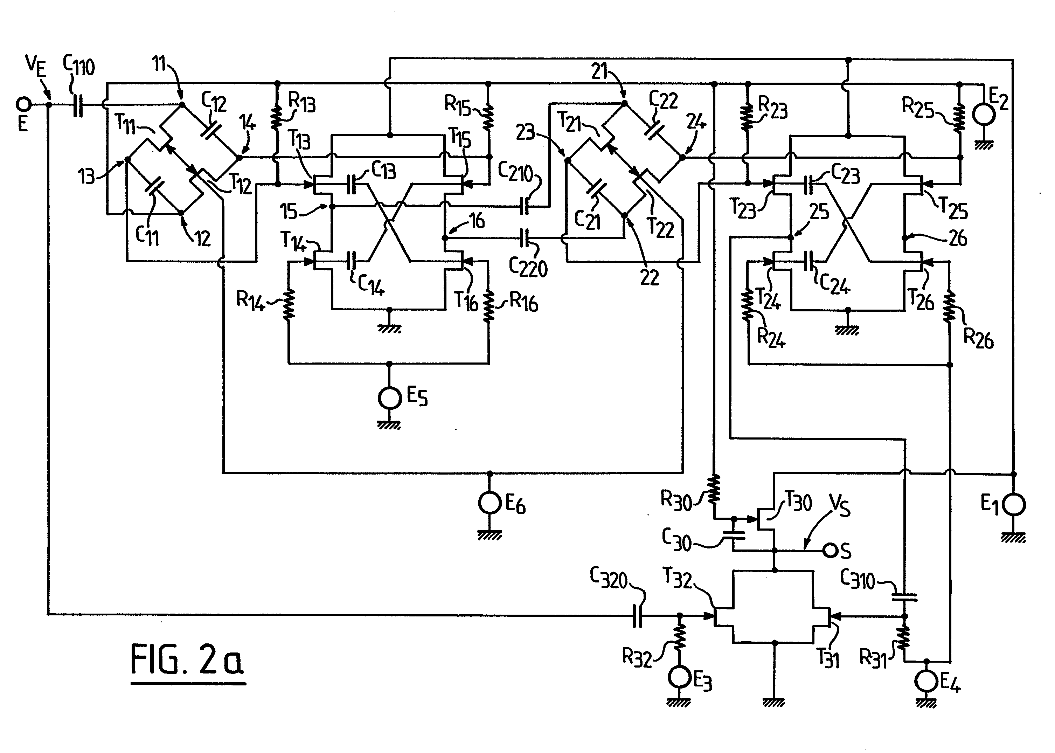

Un premier exemple de réalisation du circuit selon l'invention est représenté sur la figure 2a. Ce circuit de la figure 2a est une version de base du circuit selon l'invention, qui admet plusieurs variantes dont les caractéristiques seront exposées dans les autres exemples de réalisation.

Dans la version de la figure 2a, les blocs filtres passe-tout (AP) sont identiques. Il comprennent d'abord chacun un pont déphaseur, lequel est suivi d'un étage amplificateur différentiel PUSH-PULL.

Chaque pont déphaseur comprend entre les noeuds opposés, respectivement 11, 12 et 21, 22, pour $F_1$ et $F_2$, sur une première branche une résistance $R_{11}$, $R_{21}$, et une capacité $C_{11}$, $C_{21}$ ; et sur une seconde branche une capacité $C_{12}$, $C_{22}$ et une résistance $R_{12}$, $R_{22}$. La sortie de chaque pont déphaseur est disponible aux points communs, 13, 14 et 23, 24 respectivement pour $F_1$ et $F_2$, des résistances et capacités de chaque branche.

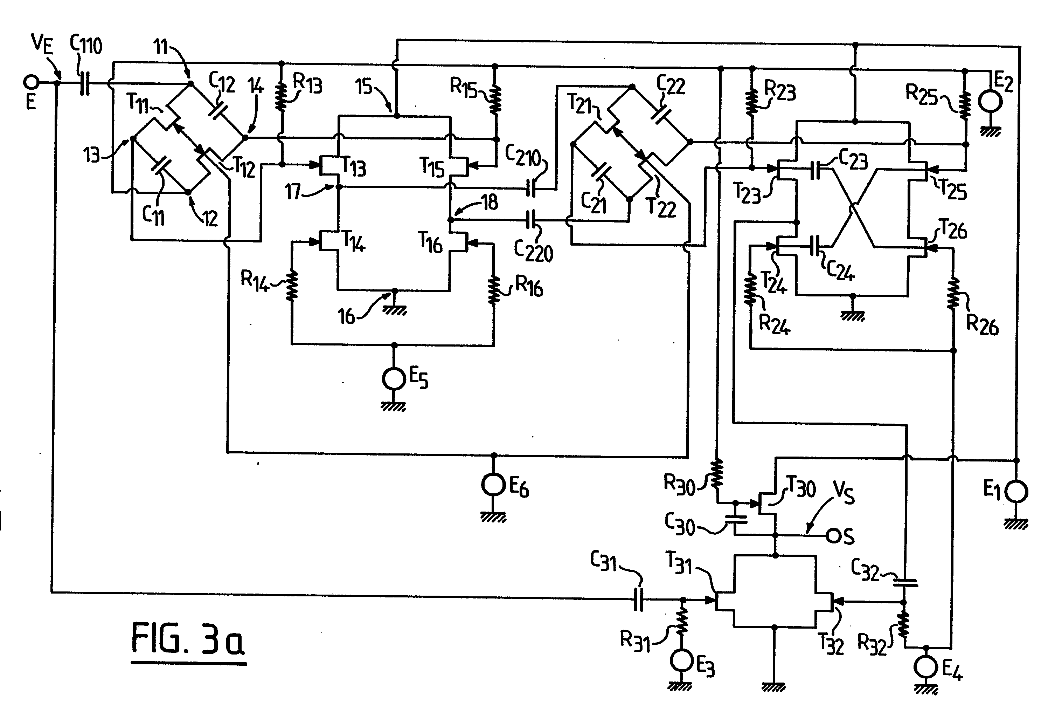

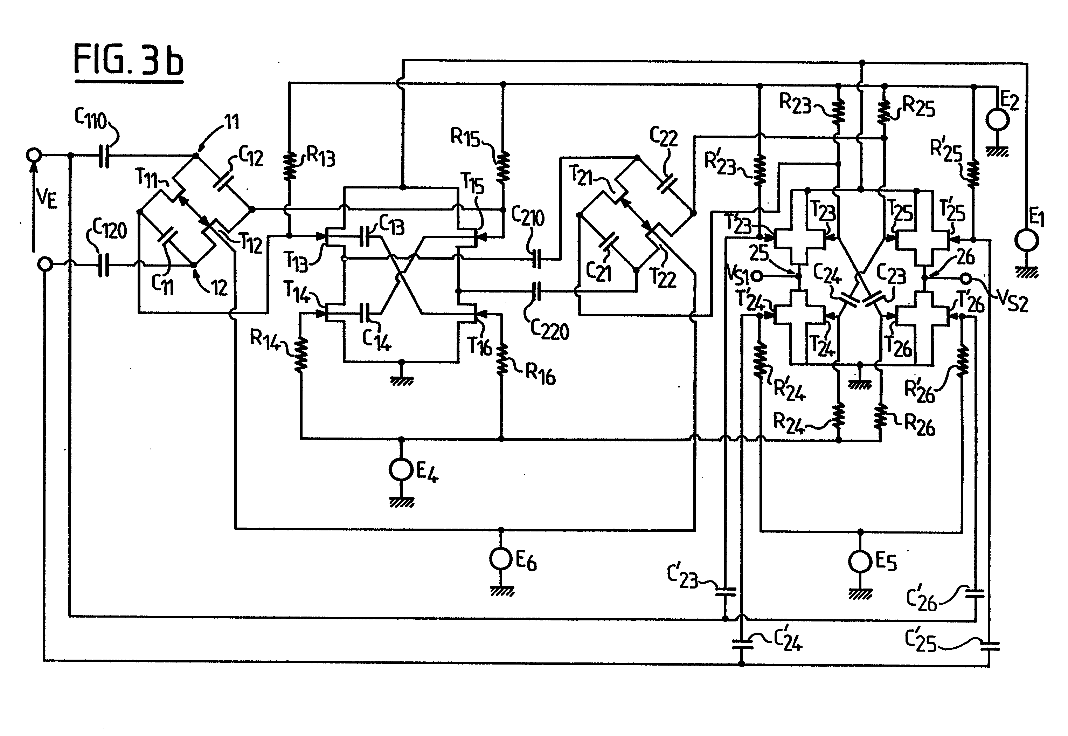

Les résistances $R_{11}$, $R_{12}$, $R_{21}$, $R_{22}$ des ponts déphaseurs sont en réalité constituées, telles que représentées sur les figures 2a, 3a, 3b, par des transistors à effet de champ (MESFET) respectivement $T_{11}$, $T_{12}$ pour le pont déphaseur du bloc $F_1$, et $T_{21}$, $T_{22}$ pour le pont déphaseur du bloc $F_2$. La source et le drain de ces transistors forment les extrémités des résistances, et leur grille reçoit une tension de polarisation $E_6$.

Ces résistances sont donc ajustables par le réglage de cette tension $E_6$ (voir figure 2a). Ce réglage permet de choisir et d'ajuster la fréquence $f_1$ de réjection du circuit selon l'invention. Une résistance placée en série avec $E_6$ permet de protéger $T_{11}$, $T_{12}$, $T_{21}$, $T_{22}$ et d'augmenter un peu $f_1$.

La fréquence maximale de réjection $f_1$ max correspond à une tension grille-source nulle ($V_{GS} = 0$) pour les transistors des ponts déphaseurs, ce qui est obtenu pour :

$E_6$ maximale $= E_2 = 2,5V$

pour l'exemple décrit (voir la figure 2a).

La fréquence minimale $f_1$ min pour la réjection R correspond à la tension minimale choisie en fonction de la tension de seuil du transistor qui peut être appliquée entre les grille et source des transistors du pont déphaseur, c'est-à-dire :

$V_{GS}$ min $= -1,8V$, ce qui est obtenu pour $E_6$ min $= E_2 - 1,8V = 0,7V$ dans cet exemple.

Le rapport entre les tensions de sortie $V_{SP}$ entre les points 13, 14 ou 23,24, et les tensions d'entrée $V_{EP}$ entre les points 11, 12 ou 21, 22 des ponts déphaseurs est donné par la relation (12) du tableau I, relation dans laquelle $R_0$ et $C_0$ sont les valeurs des résistances et des capacités des différents éléments des ponts déphaseurs.

Chaque bloc $F_1$ ou $F_2$, à fonction de passe-tout, comprend ensuite un étage amplificateur différentiel dont chaque branche est du type PUSH-PULL.

Ces amplificateurs, tels que représentés sur la figure 2a, comprennent une première branche constituée d'un transistor haut ($T_{13}$ et $T_{23}$ respectivement pour $F_1$ et $F_2$), et d'un transistor bas ($T_{14}$ et $T_{24}$ respectivement pour $F_1$ et $F_2$) en série. Cette première branche est en parallèle sur une seconde branche constituée d'un transistor haut ($T_{15}$ et $T_{25}$ respectivement) en série avec un transistor bas ($T_{16}$ et $T_{26}$ respectivement).

Les drains des transistors haut sont communs et portés à une tension d'alimentation continue $E_1$. Les sources des transistors bas sont communes et portées à la masse.

Les grilles des transistors hauts sont reliées respectivement aux noeuds de sortie du pont déphaseur qui précède l'étage amplificateur, ces noeuds étant aussi reliés en croix aux grilles des transistors bas du même étage amplificateur.

Les grilles des transistors hauts sont en outre polarisées à travers une résistance par une tension d'alimentation continue $E_2$ ($R_{13}$ pour $T_{13}$), ($R_{15}$ pour $T_{15}$), ($R_{23}$ pour $T_{23}$) et ($R_{25}$ pour $T_{25}$).

Les grilles des transistors bas sont aussi polarisées par une tension respectivement $E_5$ et $E_4$ pour les filtres $F_1$ et $F_2$. A cet effet, des capacités d'isolement (respectivement $C_{13}$, $C_{14}$ pour $F_1$ et $C_{23}$, $C_{24}$ pour $F_2$) sont interposées sur les connexions de branchement en croix des grilles des transistors hauts et bas.

La sortie de chaque étage amplificateur différentiel se fait entre les noeuds communs des transistors hauts et bas de chaque branche PUSH-PULL.

La sortie de l'étage amplificateur de $F_2$ se fait au noeud 25 entre les transistors $T_{23}$ et $T_{24}$.

D'autre part l'entrée $V_E$ de la chaîne $F_1$, $F_2$ est appliquée sur le noeud 11 du premier pont déphaseur à travers une capacité d'isolement $C_{110}$, le noeud 12 recevant une tension de polarisation $E_2$.

Les sorties 13 et 14 du premier pont déphaseur sont appliquées sur les grilles des transistors 13 et 15 des transistors hauts de l'étage amplificateur de $F_1$ et sur les grilles des transistors bas $T_{16}$ et $T_{14}$ de ce même amplificateur. Les sorties 15 et 16 de cet amplificateur sont appliquées à travers des capacités d'isolement $C_{210}$ et $C_{220}$ aux entrées 21 et 22 du pont déphaseur du bloc $F_2$. Les sorties 23 et 24 de ce pont déphaseur sont appliquées sur les grilles des transistors hauts $T_{23}$ et $T_{25}$ et sur celles des transistors bas $T_{24}$ et $T_{26}$ couplés en croix de l'étage amplificateur de $F_2$. La sortie 25 de cet étage amplificateur est disponible au point commun des transistors $T_{23}$ et $T_{25}$.

Les transistors formant les étages amplificateurs différentiels PUSH-PULL sont tous des transistors à effet de champ.

La tension de polarisation $E_4$ appliquée sur les grilles des transistors bas de l'étage amplificateur de $F_2$ sert au réglage grossier de la réjection R du circuit global, alors que la tension de polarisation $E_5$ appliquée sur les grilles des transistors bas de l'étage amplificateur de $F_1$ sert au réglage fin de cette réjection R.

Le circuit selon l'invention comprend ensuite un amplificateur $A_1$ placé en série avec les blocs $F_1$ et $F_2$. Cet amplificateur $A_1$ tel que représenté sur la figure 2a, est formé du transistor à effet de champ $T_{31}$.

La source de ce transistor $T_{31}$ est portée à la masse et son drain est porté à la tension d'alimentation $E_1$ par l'intermédiaire d'une charge. Cette charge est constituée du transistor $T_{30}$ dont le drain est porté à la tension d'alimentation $E_1$, dont la grille est polarisée à travers une résistance $R_{30}$ par la tension $E_2$, cette grille étant d'autre part reliée à sa source à travers la capacité $C_{30}$. La sortie de cet étage amplificateur $A_1$ est disponible sur le drain du transistor $T_{31}$.

La grille du transistor amplificateur $T_{31}$ (entrée de l'amplificateur $A_1$) reçoit à travers une capacité $C_{310}$ la sortie de l'étage amplificateur PUSH-PULL de $F_2$ prélevée au point commun 25 des transistor $T_{23}$, $T_{24}$.

Cette grille est d'autre part polarisée par la tension $E_4$ à travers une résistance $R_{31}$.

La tension de polarisation $E_4$ ajuste à la fois le gain $G_2$ du bloc $F_2$ et le gain $k_1$ de l'amplificateur $A_1$, elle ajuste donc grossièrement le facteur de réjection $Q_1$.

Par contre la tension de polarisation $E_5$, qui est appliquée sur les grilles des transistors bas de l'étage amplificateur PUSH-PULL du bloc $F_1$, ajuste finement le gain de cet étage amplificateur et donc ajuste finement le facteur de réjection $Q_1$.

Dans cet exemple de réalisation, on choisira :

$E_1$ = 6V

$E_2$ = 2,5V

et

$E_4$ sera ajusté pour obtenir :

$E_5 \simeq$ -0,8V.

On notera que $E_2$ peut être remplacée par un pont de résistances placé entre $E_1$ et la masse pour diminuer le nombre des sources de tensions nécessaires.

Le circuit selon l'invention comprend encore un amplificateur $A_2$ de gain $k_2$. Cet amplificateur est constitué d'un transistor à effet de champ $T_{32}$ monté en parallèle et donc admettant la même charge que le transistor $T_{31}$ ($A_1$). le transistor amplificateur $T_{32}$ reçoit sur sa grille (entrée de $A_2$) le signal d'entrée $V_E$ à travers une capacité d'isolement $C_{320}$.

Les drains communs de $T_{31}$ et $T_{32}$ réalisent la fonction du sommateur $S_3$ (voir la figure 1). La grille du transistor amplificateur $T_{32}$ ($A_2$) est en outre polarisée par une tension $E_3$. Cette tension de polarisation doit rester fixe Mais sa valeur n'est pas nécessairement très précise (on utilisera $E_3 \simeq$ - 0,8 V).

Le montage représenté sur la figure 2a, ajoute un déphasage $\pi$ sur la sortie $V_S$ disponible sur le drain commun des transistors $T_{31}$ ($A_1$) et $T_{32}$ ($A_2$) par rapport au schéma fonctionnel représenté sur la figure 1.

Pour une tension de polarisation $E_6$ des grilles des transistors des ponts déphaseurs telle que :

$E_6$ = 2,5V, la fréquence de réjection est $f_1$ = 3,23 GHz,

$E_6$ = 0,7V, la fréquence de réjection est $f_1$ = 0,90 GHz. La bande couverte est donc très large.

D'autre part, si la tension de polarisation $E_5$ est contrôlée avec une précision de ±25 mV, le circuit selon l'invention garantit :

une réjection R $\geq$ 56dB à $f_1$ = 3,23 GHz,

une réjection R $\geq$ 60dB à $F_1$ = 0,90 GHz.

Ces résultats sont très faciles à obtenir, car le circuit selon l'invention est particulièrement facile à régler. Il est en effet aisé de régler le gain de chaque étage amplificateur PUSH-PULL utilisé. C'est pourquoi justement ces amplificateurs ont été choisis de type PUSH-PULL de préférence à des amplificateurs inverseurs classiques dans chaque bloc $F_1$ et $F_2$.

On notera aussi que le gain des PUSH-PULLs'ajustant mieux aux fréquences les plus basses, la réjection y est meilleure. Elle reste cependant très élevée. Le gain basses fréquences du circuit global pour les fréquences de réjection $f_1$ les plus basses est de l'ordre de 12dB. Il est de 10dB pour les fréquences $f_1$ les plus élevées.

Les fréquences de réjection

$f_1$ = 3,23 GHz est obtenue pour $E_4$ = -1V et $E_5 \simeq$ -0,85V $f_1$ = 0,90 GHz est obtenue pour $E_4$ = -1,6V et $E_5 \simeq$ -0,95V.

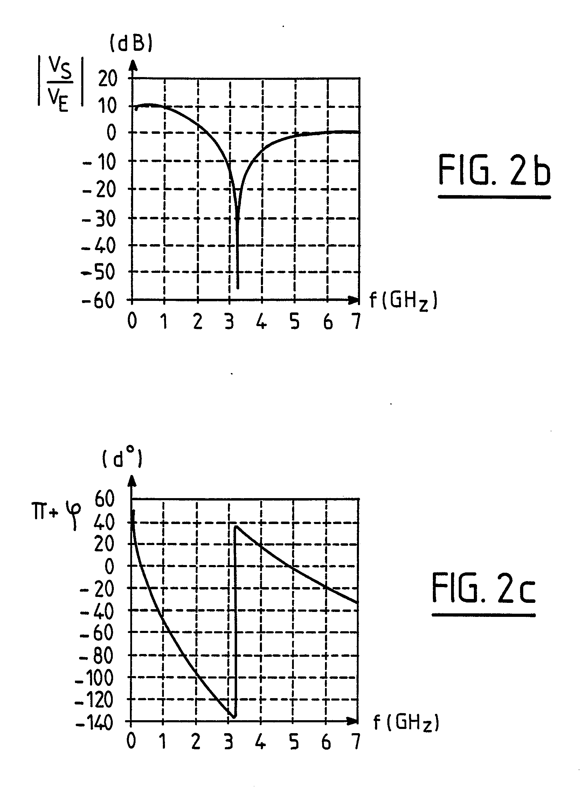

Les figures 2b et 2c donnent respectivement à titre d'exemple, les caractéristiques simulées sur ordinateur des rapports des signaux $|V_S/V_E|$ en dB en fonction de la fréquence de fonctionnement, laquelle est en GHz ; et la valeur du déphasage $\phi$ entre les signaux $V_S$ et $V_E$ en fonction de la fréquence en GHz, pour $E_4$ = -1V, $E_5$ = -0,85V, $E_6$ = 2,5V.

Le circuit selon l'invention procure notamment l'avantage de rendre $f_1$ ajustable, ce qui résulte en :

- la possibilité de rattrapage de la valeur de $f_1$ dont les circuits intégrés fournissent toujours des valeurs dispersées, du fait de la dispersion des caractéristiques des éléments d'un circuit à l'autre ;

- la possibilité d'utilisation du même circuit à de nombreuses fréquences différentes.

Le tableau II donne à titre d'exemple non limitatif, des valeurs des éléments pour la mise en oeuvre du circuit de la figure 2a, avec des transistors à effet de champ du type normalement passant en l'absence de polarisation grille-source, présentant une tension de seuil de l'ordre de :

$V_T$ = -2,5V

et une longueur de grille $\ell$ = 0,7 $\mu$m.

Le circuit selon l'invention a été réalisé au moyen des éléments du tableau II sur un substrat en arséniure de gallium (GaAs).

En reprenant l'équation (4) qui s'applique comme on l'a vu au présent circuit, on a déjà remarqué plus haut que :

6

EP 0 314 235 A1

1°/ le circuit de filtre selon l'invention est du type coupe-bande lorsque la relation (13) est vérifiée.
La structure selon l'invention permet d'obtenir $Q_1$ positif ou négatif et la relation (14) vérifiée.
2°/ le circuit selon l'invention permet aussi d'obtenir $Q_1 = -Q_0$,
ce qui correspond au cas où le circuit à la fonction de passetout. Qui plus est, le circuit selon l'invention permet de passer de la fonction de coupe-bande à la fonction de passe-tout avec les mêmes éléments.

Il suffit en effet de faire varier les polarisations de grille des transistors des différents étages, pour obtenir la variation

soit de $k_1$,

soit de $k_2$,

soit de G1,

soit de $G_2$.

On peut alors passer de manière continue de :

$Q_1 = -\infty$ (coupe-bande) à $Q_1 = -Q_0$ (passe-tout).

## Exemple de réalisation II

Ce second exemple de réalisation du circuit selon l'invention est illustré par la figure 3a. Le circuit de la figure 3a est une version qui permet de régler le gain et donc la réjection plus finement.

A cet effet, les amplificateurs des blocs $F_1$ et $F_2$ ne sont pas identiques.

L'amplificateur du bloc $F_1$ ne présente pas les grilles des transistors hauts et bas reliées en croix, donc n'est plus du type PUSH-PULL. Il est simplement constitué de deux suiveurs dont le gain est moins grand que dans l'exemple I, mais qui peut être ajusté de manière plus fine. Ainsi, la réjection est plus facile à ajuster.

Un choix peut donc être fait entre le circuit de l'exemple I et celui de l'exemple II selon l'application envisagée.

Dans cet exemple II, on utilise maintenant une tension continue $E_5 \simeq 0$, tout en lui conservant des valeurs négatives ($E_5 < 0$). Les valeurs des capacités des ponts déphaseurs sont différentes de celles de l'exemple I comme il est montré sur le tableau III.

Les fréquences de réjection obtenues sont :

$f_1 = 3,42\ GHz$     pour $E_6 = 2,5V$

$f_1 = 0,945\ GHz$     pour $E_6 = 0,7V$.

La bande couverte par la fréquence $f_1$ dans le circuit de l'exemple II est aussi un peu plus large que celle de l'exemple I.

Si la tension $E_5$ est contrôlée à ±25mV, on garantit :

$R \geq 59\ dB$     à $f_1 = 3,42GHz$

$R \geq 61\ dB$     à $f_1 = 0,945\ GHz$

Le gain aux fréquences les plus basses est équivalent à 7,5 dB du fait comme on l'a dit que les suiveurs montrent moins de gain que les PUSH-PULL de l'exemple précédent.

Pour obtenir les fréquences de réjection $f_1 = 3,42\ GHz$     il faut $E_4 = -0,85V$, $E_5 \simeq -0,19V$

$f_1 = 0,945\ GHz$     il faut $E_4 = -1,85V$, $E_5 \simeq -0,28V$.

## Exemple de réalisation III

Cet exemple a été spécialement étudié pour permettre une utilisation en différentiel (voir la figure 3b).

L'entrée $V_E = V_{E2} - V_{E1}$ différentielle est appliquée entre les noeuds 11 et 12 du pont déphaseur du premier bloc $F_1$.

La sortie peut être différentielle : ce sera $V_S = V_{S1} - V_{S2}$, la tension $V_{S1}$ étant disponible au noeud 25 de l'amplificateur différentiel du second bloc $F_2$ et la tension $V_{S2}$ au noeud 26. La sortie peut aussi être obtenue par référence à la masse, on utilisera alors l'une des tensions disponibles soit au noeud 25 soit au noeud 26.

Le bloc amplificateur $A_1$ est fusionné avec l'étage amplificateur PUSH-PULL du bloc $F_2$. A cet effet, les grilles des transistors bas $T_{24}$, $T_{26}$ de cet étage sont polarisées par la même tension continue $E_4$ que celle qui polarise les grilles des transistors bas $T_{14}$, $T_{16}$ de l'étage amplificateur PUSH-PULL du bloc $F_1$. Ceci permet d'obtenir par le réglage de $E_4$, le réglage grossier de la réjection du circuit global.

Le bloc amplificateur $A_2$ est réalisé par l'adjonction de transistors à effet de champ $T'_{23}$, $T'_{24}$, $T'_{25}$, $T'_{26}$ en parallèle respectivement sur tous les transistors $T_{23}$, $T_{24}$, $T_{25}$, $T_{26}$ de l'amplificateur PUSH-PULL

7

du bloc $F_2$. Les grilles des transistors hauts $T'_{23}$, $T'_{25}$ sont couplées en croix par le moyen des capacités $C'_{26}$, $C'_{23}$ et $C'_{25}$, $C'_{24}$ avec les grilles des transistors bas respectivement $T'_{26}$, $T'_{24}$.

D'autre part, ces grilles couplées en croix reçoivent le signal d'entrée différentiel. Ainsi, les grilles de $T'_{23}$ et $T'_{26}$ sont reliées à la borne 11 par l'intermédiaire de la capacité $C_{110}$ d'isolement en continu, et les grilles des transistors $T'_{25}$ et $T'_{24}$ sont reliées à la borne 12 par l'intermédiaire de la capacité $C_{120}$ d'isolement en continu.

Les grilles des transistors hauts $T'_{23}$ et $T'_{25}$ sont aussi polarisées par la tension continue $E_2$ à travers les résistances $R'_{23}$ et $R'_{25}$, alors que les grilles des transistors bas $T'_{24}$, $T'_{26}$ sont polarisées par la tension continue $E_5$ à travers les résistances $R'_{24}$, $R'_{26}$ pour le réglage fin de la réjection.

Le tableau III donne à titre d'exemple non limitatif des valeurs des éléments pour la mise en oeuvre du circuit de la figure 3b.

Le réglage de la fréquence $f_1$ se fait toujours par $E_6$ polarisation des grilles des transistors des ponts déphaseurs.

La sommation $S_3$ est réalisée du fait que les tansistors de $A_1$ et $A_2$ sont montés en parallèle.

Les fréquences de réjection :

$f_1$ = 3,85 GHz est obtenue pour $E_6$ max = $E_2$ = 2,5V

$f_1$ = 0,906 GHz est obtenue pour $E_6$ max = $E_2$ -1,8V = 0,7V.

La bande de fréquence couverte par $f_1$ est plus large que dans les exemples de réalisation précédemment décrits. Cela est lié au fait que lorsque la fréquence $f_1$ est élevée, les étages amplificateurs apportent un retard de phase tendant à diminuer cette fréquence $f_1$. Du fait que dans cet exemple III, la structure est telle que le circuit global comporte un étage de moins que dans les exemples I et II, la fréquence $f_1$ est moins affectée par le déphasage dû aux étages amplificateurs.

Si $E_5$ qui est le réglage fin de la réjection est contrôlée $\geq$ ±25mV, on garantit :

$R \geq 53$ dB     à $f_1$ = 3,85 GHz

$R \geq 51$ dB     à $f_1$ = 0,906 GHz

Le gain aux fréquences les plus basses est de l'ordre de 1dB si on utilise la sortie différentielle $V_S$ = $V_{S1}$ - $V_{S2}$ aux noeuds 25 et 26, et de environ -5dB si on utilise une sortie asymétrique $V_{S1}$ ou $V_{S2}$ en 25 ou en 26.

D'autre part, la fréquence de réjection $f_1$ = 3,85 GHz est obtenue pour $E_4$ = -0,8V, $E_5 \simeq$ -1,09V

$f_1$ = 0,906 GHz est obtenue pour $E_4$ = -1,95V, $E_5 \simeq$ -1,1V

avec les valeurs des éléments du tableau IV.

=========================================================================

## TABLEAU I

$$F(s) = G \cdot \frac{(s/w_1)^2 + 1}{(s/w_0)^2 + (1/Q_0)(s/w_0) + 1} \qquad (1)$$

$$p = s/w_1 \qquad (2) \qquad\qquad \frac{V_{SP}}{V_{EP}} = \frac{1 - s\, R_0 C_0}{1 + s\, R_0 C_0} \qquad (12)$$

$$s = jw \qquad (3)$$

$$G(s) = G \cdot \frac{(s/w_1)^2 + (1/Q_1)(s/w_1) + 1}{(s/w_0)^2 + (1/Q_0)(s/w_0) + 1} \qquad (4)$$

$$R = \frac{|F(jw)| \ \text{maximale}}{|F(jw)| \ \text{minimale}} \approx \frac{|F(0)|}{|F(jw_1)|} \approx \frac{|Q_1|}{Q_0} \qquad (5)$$

$$G_1(s) = G_1 \times \frac{1 - s\tau'_1}{1 + s\tau_1} \qquad (6) \qquad\qquad |Q_1| > Q_0 \qquad (13)$$

$$G_2(s) = G_2 \times \frac{1 - s\tau'_2}{1 + s\tau_2} \qquad (7) \qquad\qquad 1/Q_1 = 0 \qquad (14)$$

$$w_0 = (\tau_1 \tau_2)^{-\frac{1}{2}} \qquad (8)$$

$$w_1 = \left( \frac{k_1 + k_2\, G_1\, G_2}{k_1\, \tau_1\, \tau_2 + k_2\, G_1\, G_2\, \tau'_1\, \tau'_2} \right)^{\frac{1}{2}} \qquad (9)$$

$$Q_0 = \frac{(\tau_1\, \tau_2)^{\frac{1}{2}}}{\tau_1 + \tau_2} \qquad (10)$$

$$G = k_1 + k_2\, G_1\, G_2 \qquad (11)$$

$$Q_1 = \frac{(K_1\, \tau_1\, \tau_2 + k_2\, G_1\, G_2\, \tau'_1\, \tau'_2)^{\frac{1}{2}}}{K_1(\tau_1 + \tau_2) - k_2\, G_1\, G_2\, (\tau'_1 + \tau'_2)} \qquad (16)$$

9

| TABLEAU II (Fig.2a) | | | | | | | |
|---|---|---|---|---|---|---|---|
| Résistances | | Capacités | | Transistors | | Alimentation | |
| R | $k\Omega$ | $C_{11}$ | pF | $T\ (\ell)$ | $\mu m$ | E | V |
| $R_{13}$ | 10 | $C_{11}$ | 0,13 | $T_{11}$ | 10 | $E_1$ | 6 |
| $R_{15}$ | 10 | $C_{12}$ | 0,13 | $T_{12}$ | 10 | $E_2$ | 2,5V |
| $R_{14}$ | 10 | $C_{13}$ | 1 | $T_{13}$ | 40 | $E_3$ | -0,8 |
| $R_{16}$ | 10 | $C_{14}$ | 1 | $T_{14}$ | 40 | $E_4$ | |
| $R_{23}$ | 10 | $C_{21}$ | 0,13 | $T_{15}$ | 40 | $E_5$ | |
| $R_{25}$ | 10 | $C_{22}$ | 0,13 | $T_{16}$ | 40 | $E_6$ | |
| $R_{24}$ | 10 | $C_{23}$ | 1 | $T_{21}$ | 10 | | |
| $R_{26}$ | 10 | $C_{24}$ | 1 | $T_{22}$ | 10 | | |
| $R_{30}$ | 10 | $C_{30}$ | 1 | $T_{23}$ | 40 | | |
| $R_{31}$ | 10 | $C_{310}$ | 1 | $T_{24}$ | 40 | | |
| $R_{32}$ | 10 | $C_{320}$ | 1 | $T_{25}$ | 40 | | |
| | | $C_{110}$ | 1 | $T_{26}$ | 40 | | |
| | | $C_{210}$ | 1 | $T_{30}$ | 25 | | |
| | | $C_{220}$ | 1 | $T_{31}$ | 35 | | |
| | | | | $T_{32}$ | 10 | | |

$E_4$ = réglage grossier de la réjection R

$E_5$ = réglage fin de la réjection R

$E_6$ = réglage de la fréquence $f_1$ de réjection

## TABLEAU III (Fig.3a)

| $R$ | $k\Omega$ | $C_{11}$ | $pF$ | $T\,(\ell)$ | $\mu m$ | $E$ | $V$ |
|---|---|---|---|---|---|---|---|
| $R_{13}$ | 10 | $C_{11}$ | 0,12 | $T_{11}$ | 10 | $E_1$ | 6 |
| $R_{14}$ | 10 | $C_{12}$ | 0,12 | $T_{12}$ | 10 | $E_2$ | 2,5V |
| $R_{15}$ | 10 | $C_{21}$ | 0,12 | $T_{13}$ | 40 | $E_3$ | −0,8 |
| $R_{16}$ | 10 | $C_{22}$ | 0,12 | $T_{14}$ | 25 | $E_4$ | |
| $R_{23}$ | 10 | $C_{23}$ | 1 | $T_{15}$ | 40 | $E_5$ | |
| $R_{24}$ | 10 | $C_{24}$ | 1 | $T_{16}$ | 25 | $E_6$ | |
| $R_{25}$ | 10 | $C_{30}$ | 1 | $T_{21}$ | 10 | | |
| $R_{26}$ | 10 | $C_{31}$ | 1 | $T_{22}$ | 10 | | |
| $R_{30}$ | 10 | $C_{32}$ | 1 | $T_{23}$ | 40 | | |
| $R_{31}$ | 10 | $C_{110}$ | 1 | $T_{24}$ | 40 | | |
| $R_{32}$ | 10 | $C_{210}$ | 1 | $T_{25}$ | 40 | | |
| | | $C_{220}$ | 1 | $T_{26}$ | 40 | | |
| | | | | $T_{30}$ | 45 | | |
| | | | | $T_{31}$ | 10 | | |
| | | | | $T_{32}$ | 70 | | |

$E_4$ = réglage grossier de la réjection R

$E_5$ = réglage fin de la réjection R

$E_6$ = réglage de la fréquence $f_1$ de réjection

**TABLEAU IV (Fig.3b)**

| Résistances | | Capacités | | Transistors | | Alimentation | |
|---|---|---|---|---|---|---|---|
| R | kΩ | $C_{11}$ | pF | T (ℓ) | µm | E | V |
| $R_{13}$ | 10 | $C_{11}$ | 0,13 | $T_{11}$ | 10 | $E_1$ | 6 |
| $R_{14}$ | 10 | $C_{12}$ | 0,13 | $T_{12}$ | 10 | $E_2$ | 2,5 |
| $R_{15}$ | 10 | $C_{13}$ | 1 | $T_{13}$ | 40 | $E_4$ | |
| $R_{16}$ | 10 | $C_{14}$ | 1 | $T_{14}$ | 40 | $E_5$ | |
| $R_{23}$ | 10 | $C_{21}$ | 0,13 | $T_{15}$ | 40 | $E_6$ | |
| $R'_{23}$ | 10 | $C_{22}$ | 0,13 | $T_{16}$ | 40 | | |
| $R_{24}$ | 10 | $C_{23}$ | 1 | $T_{21}$ | 10 | | |
| $R'_{24}$ | 10 | $C_{24}$ | 1 | $T_{22}$ | 10 | | |
| $R_{25}$ | 10 | $C'_{23}$ | 1 | $T_{23}$ | 30 | | |
| $R'_{25}$ | 10 | $C'_{24}$ | 1 | $T'_{23}$ | 10 | | |
| $R_{26}$ | 10 | $C'_{25}$ | 1 | $T_{24}$ | 30 | | |
| $R'_{26}$ | 10 | $C'_{26}$ | 1 | $T'_{24}$ | 10 | | |
| | | $C_{110}$ | 1 | $T_{25}$ | 30 | | |
| | | $C_{120}$ | 1 | $T'_{25}$ | 10 | | |
| | | $C_{210}$ | 1 | $T_{26}$ | 30 | | |
| | | $C_{220}$ | 1 | $T'_{26}$ | 10 | | |

$E_4$ = réglage grossier de la réjection R

$E_5$ = réglage fin de la réjection R

$E_6$ = réglage de la fréquence $f_1$ de réjection

## Revendications

1. Circuit formant un filtre R.C. actif pour application coupe-bande dans les domaines des hautes et hyperfréquences, à fonction de transfert biquadratique, comportant une chaîne comprenant un bloc pour réaliser une fonction filtre et amplificateur, et comportant un bloc $S_3$ pour réaliser la sommation $V_S$ entre le signal de sortie de la chaîne et le signal $V_E$ appliqué à l'entrée E du circuit, caractérisé en ce que le bloc filtre est constitué de deux blocs filtre $F_1$ et $F_2$ à fonction de passe-tout chacun d'ordre 1 en série, et en ce que la chaîne comprend en outre un bloc amplificateur $A_1$ en série avec le bloc filtre $F_1$, $F_2$, placé entre la sortie de ces derniers et la sortie de la chaîne, en ce que le signal d'entrée $V_E$ est appliqué par ailleurs sur

le bloc sommateur $S_3$ à travers un amplificateur $A_2$, et en ce que le bloc $S_3$ sommateur est formé par le couplage des sorties des blocs amplificateurs $A_1$ et $A_2$ pour former la sortie S du circuit sur laquelle le signal de sortie $V_S$ est disponible.

2. Circuit selon la revendication 1, caractérisé en ce que chaque bloc $F_1$ et $F_2$ comprend un pont déphaseur associé à un étage amplificateur.

3. Circuit selon la revendication 2, caractérisé en ce que chaque pont déphaseur est formé, entre les deux noeuds d'entrée de deux branches parallèles, la première branche comportant dans l'ordre une dite première résistance et une dite première capacité, notées $T_{11}$ et $C_{11}$ pour le pont déphaseur du bloc $F_1$, et notées $T_{21}$ et $C_{21}$ pour le pont déphaseur du bloc $F_2$, la seconde branche comportant dans l'ordre une dite seconde capacité et une dite seconde résistance, notées $C_{12}$ et $T_{12}$ pour $F_1$ et notées $C_{22}$ et $T_{22}$ pour $F_2$; les sorties de chaque pont se faisant entre les noeuds formés par les points communs des résistances et capacités de chaque branche.

4. Circuit selon la revendication 3, caractérisé en ce que les résistances des ponts déphaseurs sont ajustables pour régler la fréquence de réjection $f_1$ du circuit global.

5. Circuit selon la revendication 4, caractérisé en ce que les résistances ajustables des ponts déphaseurs sont constituées par des transistors à effet de champ dont la grille est polarisée par une tension ajustable $E_6$.

6. Circuit selon l'une des revendications 2 à 5, caractérisé en ce que les étages amplificateurs associés aux ponts déphaseurs dans chaque bloc passe-tout $F_1$, $F_2$ sont du type amplificateur différentiel.

7. Circuit selon la revendication 6, caractérisé en ce que les amplificateurs différentiels sont formés de deux branches en parallèle entre une tension d'alimentation continue $E_1$ et la masse, la première branche comportant un transistor dit haut respectivement pour $F_1$ et $F_2$, les transistors $T_{13}$, $T_{23}$, et d'un transistor dit bas en série, respectivement $T_{14}$, $T_{24}$, la seconde branche comportant un transistor dit haut, respectivement pour $F_1$, $F_2$, les transistors $T_{15}$, $T_{25}$, et un transistor dit bas en série respectivement $T_{16}$, $T_{26}$, les grilles des transistors hauts recevant les signaux des noeuds de sortie du pont déphaseur qui les précède et étant polarisées par une tension $E_2$ à travers des résistances de protection, et les grilles des transistors bas étant polarisées par une tension à travers des résistances de protection, les sorties de chaque étage amplificateur différentiel se faisant au point commun des transistors hauts et bas des branches.

8. Circuit selon la revendication 7, caractérisé en ce que les grilles des transistors hauts et bas de l'étage amplificateur différentiel du second bloc $F_2$ sont reliées en croix à travers des capacités d'isolement en continu, formant un amplificateur de type PUSH-PULL.

9. Circuit selon la revendication 7, caractérisé en ce que les grilles des transistors hauts et bas de l'étage amplificateur différentiel du premier bloc $F_1$ sont aussi reliées en croix à travers des capacités d'isolement en continu.

10. Circuit selon l'une des revendications 8 ou 9, caractérisé en ce que le signal d'entrée du circuit $V_E$ est appliqué sur l'un des noeuds d'entrée 11 du pont déphaseur du premier bloc $F_1$, l'autre noeud d'entrée 12 étant porté à la tension de référence continue $E_2$ et en ce que les grilles des transistors bas de l'étage amplificateur différentiel du bloc $F_2$ sont polarisées par une tension $E_4$ variable pour l'ajustement grossier de la réjection R du circuit global, et en ce que les grilles des transistors bas de l'étage amplificateur différentiel du bloc $F_1$ sont polarisées par une tension $E_5$ variable pour l'ajustement fin de la réjection R du circuit global.

11. Circuit selon la revendication 10, caractérisé en ce que le bloc amplificateur $A_1$ est formé d'un transistor à effet de champ $T_{31}$ dont la source est reliée à la masse, le drain à la sortie S, et dont la grille reçoit à travers une capacité $C_{310}$ le signal de sortie du second bloc passe-tout $F_2$, le drain de ce transistor $T_{31}$ étant en outre porté à la tension d'alimentation $E_1$ à travers une charge et la grille de ce transistor $T_{31}$ étant polarisée à travers une résistance $R_{31}$ par une source de tension continue $E_4$ réglable pour faire varier le gain ($k_1$) de ce bloc amplificateur, et en ce que le bloc amplificateur $A_2$ est formé d'un transistor à effet de champ $T_{32}$ monté en parallèle sur le transistor $T_{31}$ pour réaliser la sommation $S_3$, la grille du transistor $T_{32}$ recevant à travers une capacité $C_{320}$ le signal d'entrée $V_E$ du circuit et étant de plus polarisée à travers une résistance $R_{32}$ par la source de tension $E_3$ pour faire varier le gain ($k_2$) de ce bloc amplificateur.

12. Circuit selon la revendication 11, caractérisé en ce que la charge des transistors $T_{31}$ et $T_{32}$ des amplificateurs $A_1$ et $A_2$ est une charge active formée d'un transistor à effet de champ $T_{30}$ dont la source est reliée aux drains communs des transistors $T_{31}$ et $T_{32}$, et dont le drain est porté à l'alimentation continue $E_1$, la polarisation de la grille du transistor $T_{30}$ étant réalisée du fait qu'elle est reliée à une tension continue $E_2$, à travers une résistance $R_{30}$, et cette grille étant en outre reliée à la source de $T_{30}$ à travers une capacité $C_{30}$.

13. Circuit selon la revendication 10, caractérisé en ce que, pour recevoir une entrée différentielle $V_E$ = $V_2$ - $V_1$ et fournir une sortie différentielle $V_S$ = $V_{S2}$ - $V_{S1}$, l'entrée différentielle est appliquée entre les noeuds d'entrée 11 et 12 du pont déphaseur du premier bloc $F_1$, en ce que le bloc amplificateur $A_1$ est réalisé par l'étage amplificateur différentiel du second bloc $F_2$, du fait que les grilles des transistors bas $T_{24}$, $T_{26}$ de ce bloc $F_2$ sont polarisées par la même tension continue que la tension qui polarise les grilles des transistors bas de l'étage amplificateur différentiel du premier bloc $F_1$, par exemple $E_4$, pour obtenir le réglage grossier de la réjection, en ce que le bloc amplificateur $A_2$ est réalisé par l'adjonction de transistors à effet de champ $T'_{23}$, $T'_{24}$, $T'_{25}$, $T'_{26}$, en parallèle, sur chacun des transistors hauts $T_{23}$, $T_{25}$ et bas $T_{24}$, $T_{26}$ respectivement des deux branches de l'étage amplificateur différentiel du bloc $F_2$, les grilles d'un transistor haut et d'un transistor bas couplées en croix, respectivement $T'_{23}$, $T'_{26}$ étant reliées à l'un des bornes 11 de l'entrée différentielle, et les grilles des autres transistors hauts et bas respectivement $T'_{25}$, $T'_{24}$, couplées en croix étant reliées à l'autre borne 12 de l'entrée différentielle, ce second bloc $F_2$ assurant ainsi la sommation $S_3$, en ce que les grilles de ces transistors bas $T'_{24}$, $T'_{26}$ sont polarisées par une tension $E_5$ par l'intermédiaire des résistances $R'_{24}$ et $R'_{26}$ pour le réglage fin de la réjection, en ce que les grilles des ces transistors hauts $T'_{23}$, $T'_{25}$ sont polarisées par la tension $E_1$ à travers des résistances $R'_{23}$ et $R'_{25}$ et en ce que la sortie différentielle $V_S$ du circuit global est disponible entre les points communs 25 et 26 des transistors hauts et bas sur chaque branche.

14. Circuit selon l'une des revendications 11, 12 ou 13, caractérisé en ce qu'il présente la fonction d'un coupe-bande par le réglage des valeurs des tensions $E_1$, $E_2$, $E_3$, $E_4$, $E_5$, $E_6$ relativement les unes par rapport aux autres pour obtenir des gains $k_1$, $k_2$, $G_1$, $G_2$ des blocs amplificateurs tels que la réjection R de ce circuit est supérieure à 1.

15. Circuit selon l'une des revendications 11, 12 ou 13, caractérisé en ce qu'il présente la fonction d'un passe-tout par le réglage des valeurs des tensions $E_1$, $E_2$, $E_3$, $E_4$, $E_5$, $E_6$, relativement les unes par rapport aux autres pour obtenir des gains $k_1$, $k_2$, $G_1$, $G_2$ des blocs amplificateurs tels que le facteur de réjection $Q_1$ est opposé au facteur de qualité $Q_0$.

16. Circuit selon l'une des revendications 11, 12 ou 13, caractérisé en ce que, par le réglage des valeurs des tensions $E_3$ et $E_4$ par rapport aux tensions $E_1$, $E_2$, $E_5$, $E_6$ pour obtenir des variations des gains $k_1$, $k_2$, et $G_1$, $G_2$, il en résulte une variation continue du facteur de réjection $Q_1$ entre $-\infty$ et $+\infty$.

17. Circuit selon l'une des revendications 5 à 16, caractérisé en ce qu'il est intégré sur un substrat en arséniure de gallium (GaAs) et réalisé au moyen de transistors à effet de champ du type normalement passant en l'absence de polarisation grille-source.

FIG.1

FIG. 2a

EP 0 314 235 A1

2-Ⅱ-PHF 87-586

FIG. 2b

FIG. 2c

FIG. 3a

EP 0 314 235 A1

4 - Ⅴ - PHF 87 - 586

FIG. 3b

EP 0 314 235 A1

5-Ⅳ-PHF 87-586

# DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | US-A-4 001 712  (CHAMBERS et al.) <br> * En entier * <br> --- | 1 | H 03 H   11/04 <br> H 03 H   11/18 |
| A | PATENT ABSTRACTS OF JAPAN, vol. 10, no. 255 (E-433)[2311], 2 septembre 1986, page 99 E 433; & JP-A-61 82 515 (TOSHIBA CORP.) 26-04-1986 <br> * Résumé * <br> --- | 1 | |
| A | IEEE TRANSACTIONS ON INSTRUMENTATION AND MEASUREMENT, vol. IM23, no. 2, juin 1974, pages 182-183, IEEE, New York, US; S.K. SAHA: "Inductorless all-pass phase-shifters" <br> * En entier * <br> --- | 1 | |
| A | ELECTRONICS LETTERS, vol. 6, no. 6, 19 mars 1970, pages 183-185, Londres, GB; P. WILLIAMS: "Allpass networks using Wien's bridge" <br> * En entier * <br> --- | 2,6 | **DOMAINES TECHNIQUES RECHERCHES (Int. Cl.4)** |
| A | TELECOMMUNICATION & RADIO ENGINEERING, vol. 30/31, no. 6, juin 1976, pages 51-55, Washington, US; V.B. MINUKHIN: "Active RC-equivalent of a second-order all-pass circuit" <br> * En entier * <br> ----- | 2,3,5 | H 03 H |

Le présent rapport a été établi pour toutes les revendications

| Lieu de la recherche | Date d'achèvement de la recherche | Examinateur |
|---|---|---|
| LA HAYE | 03-02-1989 | COPPIETERS C. |

EPO FORM 1503 03.82 (P0402)